# EUROPEAN PATENT APPLICATION

(11) **EP 4 625 001 A1**
(43) Date of publication of application: **01.10.2025**
(21) Application number: 23894734.5
(22) Date of filing: 29.08.2023
(51) Int. Cl.: G01W 1/06, G06F 30/20

(54) **METHOD FOR ESTIMATING STRONGEST POSSIBLE FUTURE TYPHOON FOR NUCLEAR POWER PLANT SITE**

(30) Priority: 25.11.2022 KR 20220160008
(71) Applicant: Korea Hydro & Nuclear Power Co., Ltd, Gyeongju-si, Gyeongsangbuk-do 38120 (KR)
(72) Inventor: RYU, Jae Woong, Sejong 30127 (KR)
(74) Representative: Habermann, Hruschka & Schnabel
(86) International application number: PCT/KR2023/012773
(87) International publication number: WO 2024/111802

(57) **Abstract**

The present disclosure relates to a method of calculating a future possible maximum typhoon for a nuclear power plant site, and the method includes analyzing historical typhoons to select a previous maximum typhoon as a reference typhoon, and calculating the future possible maximum typhoon by strengthening the reference typhoon using an ocean-atmosphere coupled model.

## Description

### Technical Field

The present disclosure relates to a method of calculating a future possible maximum typhoon for a nuclear power plant site.

### Background Art

Natural disaster coping technology for an existing nuclear power plant site includes assessing an influence of flooding (sea level) from a storm surge caused by a typhoon as an external hazard factor.

In sea level assessment for a nuclear power plant site design basis, an increase in sea temperature due to future climate change should be reflected in consideration of an expiration period of a designed lifetime of the nuclear power plant to strengthen a historical (reference) typhoon into a future typhoon.

A method of 1) increasing a maximum wind speed of a reference typhoon to a level of a super typhoon, or 2) increasing the maximum wind speed by applying an Atlantic typhoon intensity empirical formula (sea surface temperature vs maximum wind speed) and an atmospheric model has been used so far.

### Disclosure

### Technical Problem

Therefore, an object of the present disclosure is to provide a method of calculating a future possible maximum typhoon for a nuclear power plant site using a latest regional climate model.

### Technical Solution

The object of the present disclosure is achieved by a method of calculating a future possible maximum typhoon for a nuclear power plant site, the method including: analyzing historical typhoons to select a previous maximum typhoon as a reference typhoon; and calculating the future possible maximum typhoon by strengthening the reference typhoon using an ocean-atmosphere coupled model.

The strengthening of the reference typhoon may include using a future sea surface temperature rise value in a site area as an ocean-atmosphere boundary value of the ocean-atmosphere coupled model; and considering a water depth-specific future sea temperature profile.

The ocean-atmosphere coupled model may simulate a sea surface cooling effect due to an interaction between a typhoon and the ocean using the future sea surface temperature rise value and the water depth-specific future sea temperature profile.

The site area may include the nuclear power plant site and a sea area around the nuclear power plant site, and the future sea surface temperature rise value may be obtained based on a sea surface temperature in the site area at the reference typhoon, and a scenario-based sea surface temperature rise value.

For the water depth-specific future sea temperature profile, a sea temperature distribution in the site area in a period of time of the reference typhoon and a water depth-specific change rate predicted by a climate model may be used in combination. Advantageous Effects

According to the present disclosure, a method of calculating a future possible maximum typhoon for a nuclear power plant site is provided.

### Description of Drawings

FIG. 1 illustrates an overview of an ocean-atmosphere coupled model according to an embodiment of the present disclosure.
FIG. 2 is a diagram illustrating a sea surface cooling effect according to an embodiment of the present disclosure.
FIG. 3 illustrates an example of a climate model-based future sea temperature profile in an embodiment of the present disclosure.
FIG. 4 illustrates an example of a HYCOM-based future sea temperature profile in an embodiment of the present disclosure.

### Mode for Disclosure

The present disclosure forcibly considers a future sea surface temperature rise value for a sea surface boundary value of an ocean-atmosphere coupled model, and simulates a sea surface cooling effect due to a typhoon-ocean interaction using a water depth-specific future sea temperature profile. This makes it possible to prevent over-simulation in a strong wind area when only an Atlantic typhoon intensity empirical formula and an atmospheric model are used, thereby reducing an amount of sea level rise and minimizing flooding of a nuclear power plant site due to wave overtopping and an influence of wave pressure on safety structures.

Hereinafter, the present disclosure will be described in detail with reference to the drawings.

The present disclosure below can be performed through a computer and a communication means (intranet, Internet, or the like).

In the present disclosure, historical typhoons are first analyzed and a previous maximum typhoon in history is selected as a reference typhoon.

Thereafter, since a design lifetime of each nuclear power plant is conservatively considered in accordance with a nuclear power plant design basis (US NRC), the reference typhoon is strengthened using an ocean-atmosphere coupled model, which is the latest regional climate model, to calculate a possible maximum typhoon in a future period of time that is a lifetime expiration time point.

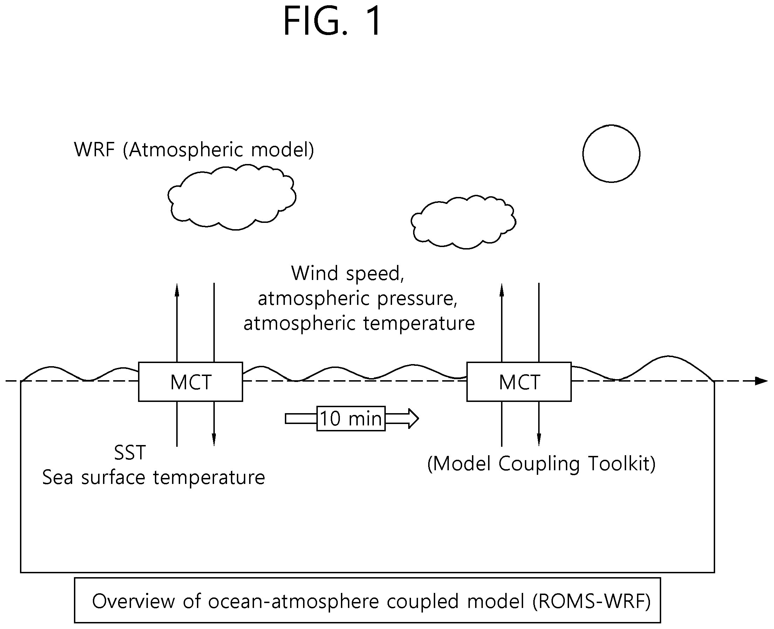

A numerical model is called a Coupled Ocean-Atmosphere-Wave-Sediment Transport (COAWST) model system, and the COAWST model system includes a Regional Ocean Modeling System (ROMS) ocean model, a Weather Research Forecasting (WRF) atmospheric model, a Simulating Waves Nearshore (SWAN) wave model, and a Community Sediment Transport Modeling System (SCTMS) sediment model. The ocean model (ROMS) is combined with the atmospheric model (WRF), which is also called an ocean-atmosphere coupled model. The ocean-atmosphere coupled model exchanges variables (sea surface temperature, wind speed, atmospheric pressure, and atmospheric temperature) every 10 minutes through a Model Coupling Toolkit (MCT) coupler, as in FIG. 1.

In strengthening the reference typhoon, a future sea surface temperature rise value in a site area is used as an ocean-atmosphere boundary value of the ocean-atmosphere coupled model, and the water depth-specific future sea temperature profile is considered.

The reference typhoon and future possible maximum typhoon may include wind speed and atmospheric pressure, which may be used as input data in a numerical analysis stage in which a highest possible sea level is calculated.

For a topographic data used in the atmospheric model (WRF), USGS 30-second high-resolution topographic data may be used, and a horizontal resolution of the model may be set to 5 km. Domains of the atmospheric model (WRF) and the ocean model (ROMS) are the same, and are set so that the typhoon can be developed sufficiently before the typhoon approaches and lands on the Korean Peninsula.

The ocean-atmosphere coupled model simulates the sea surface cooling effect caused by an interaction between the typhoon and the ocean using the future sea surface temperature rise value and the water depth-specific future sea temperature profile.

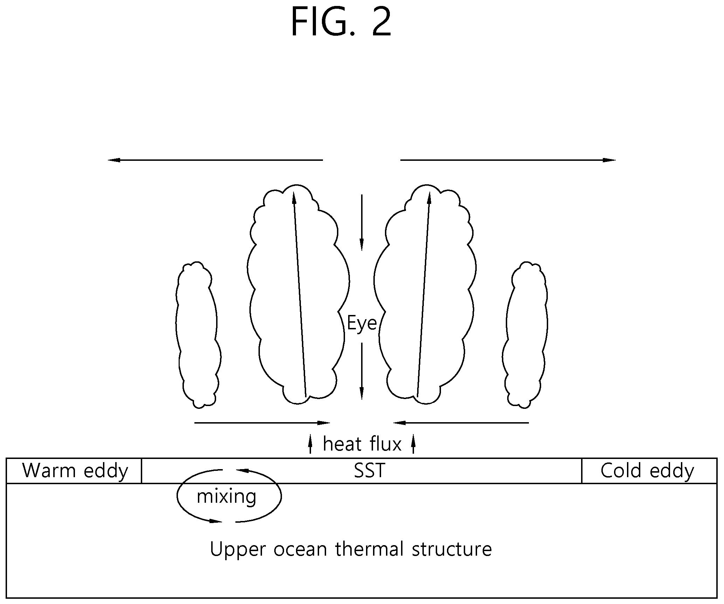

The simulation of the sea surface cooling effect refers to a cooling phenomenon that occurs due to vertical mixing and an upwelling effect of upper ocean in a period of time in which the typhoon occurs, as in FIG. 2, and the vertical mixing is a process in which turbulence occurs in an upper layer of the ocean due to strong wind at the sea surface, which causes cold sea water in a lower layer and a warm sea water in the upper layer to be mixed. Further, in the upwelling effect, sea water in the upper layer of the ocean diverges due to rotating nature of the typhoon, and sea water in the lower layer upwells in a center portion. Therefore, a lowered sea surface temperature serves to decrease energy supplied to the typhoon.

Current (HYCOM_CTRL) and future (HYCOM_10, HYCOM_40) sea temperature profiles for each water depth are used in the ocean model (ROMS), which is one of components of the ocean-atmosphere coupled model. Several other variables (salinity, ocean current, sea surface, and the like) are used together in the ocean model, but the present disclosure is characterized by usage of current and future sea surface temperature (SST) and a water depth-specific profile.

The future sea surface temperature rise value can be obtained based on the sea surface temperature and a scenario-based sea surface temperature rise value in the site area at the reference typhoon.

In a scenario, for example, a scenario-based sea surface temperature rise value from the IPCC 6th Climate Change Report may be used.

For the water depth-specific future sea temperature profile, a sea temperature distribution in the site area in a period of time of the reference typhoon and a water depth-specific change rate predicted by the climate model may be used in combination.

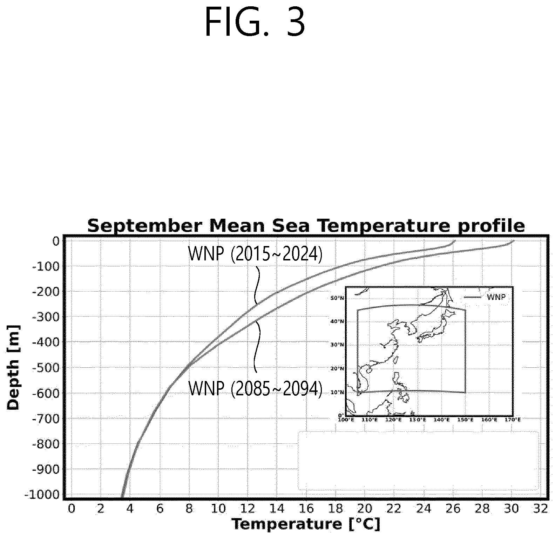

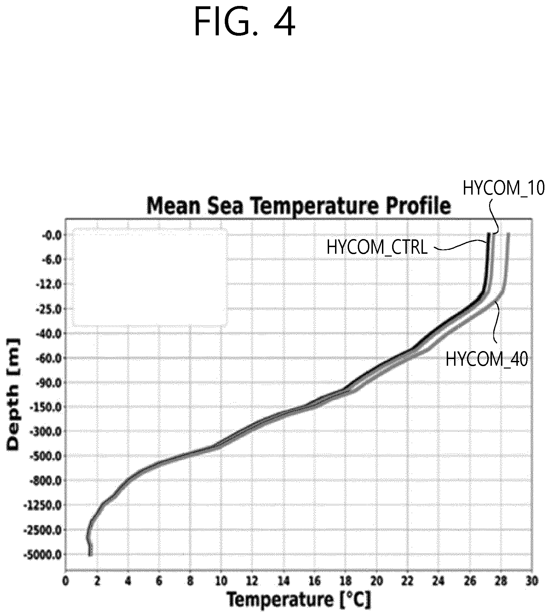

In numerical analysis of the ocean-atmosphere coupled model, three-dimensional sea temperature profile data is required at each ocean grid point, and hybrid coordinate ocean model (HYCOM) data as shown in FIG. 4 may be used. Three-dimensional ocean sea temperature data 10 and 40 years later in the future may reflect a fluctuation trend of the sea temperature profile for 70 years in the future in the western north pacific predicted by a CMIP6 CMCC-ESM2 climate model (FIG. 3). That is, a future sea temperature change rate for each water depth may be applied to a current HYCOM 3D profile.

In FIG. 3, WNP (2015 - 2024) represents a mean sea temperature profile at a Western North Pacific (WNP indicated in a green box) region in a current climate (2015 - 2014), and WNP (2085-2094) represents a mean value in a future climate (2085 - 2094). It can be seen from this result that a future sea temperature change is greatest in a surface layer and tends to decrease as a water depth increases, and there is substantially no change in sea temperature in a water depth of 500 m or less.

Thus, in the present disclosure, 1) the future sea surface temperature rise value is forcibly considered in a sea area around the nuclear power plant site and the Korean Peninsula as input data for the ocean-atmosphere coupled model that can simulate the sea surface cooling effect, and 2) an analytical scheme for calculating a future possible maximum typhoon at the nuclear power plant site using the water depth-specific future sea temperature profile is used.

A methodology according to the present disclosure is applied, it is possible to reduce an amount of sea level rise amount by simulating the sea surface cooling effect due to a typhoon-sea interaction in the sea area around the nuclear power plant site and the Korean Peninsula, rather than in an Atlantic environment.

According to the present disclosure as described above, it is possible to obtain a reduction in a highest possible sea level rise amount from a storm surge caused by a possible maximum typhoon compared to a nuclear power plant site height (about 10 m).

Further, it is possible to minimize flooding of the nuclear power plant site and an influence on safety structures due to the reduction in the highest possible sea level rise amount.

The above-described embodiments are examples for describing the present disclosure, and the present disclosure is not limited thereto. Since those skilled in the art to which the present disclosure pertains will be able to implement the present disclosure through various modifications of the embodiments, the technical protection scope of the present disclosure should be determined by the appended claims.

## Claims

1. A method of calculating a future possible maximum typhoon for a nuclear power plant site, the method comprising:
analyzing historical typhoons to select a previous maximum typhoon as a reference typhoon; and
calculating the future possible maximum typhoon by strengthening the reference typhoon using an ocean-atmosphere coupled model.

2. The method of claim 1, wherein the strengthening of the reference typhoon includes
using a future sea surface temperature rise value in a site area as an ocean-atmosphere boundary value of the ocean-atmosphere coupled model; and
considering a water depth-specific future sea temperature profile.

3. The method of claim 2, wherein the ocean-atmosphere coupled model simulates a sea surface cooling effect due to an interaction between a typhoon and the ocean using the future sea surface temperature rise value and the water depth-specific future sea temperature profile.

4. The method of claim 1, wherein
the site area includes the nuclear power plant site and a sea area around the nuclear power plant site, and
the future sea surface temperature rise value is obtained based on a sea surface temperature in the site area at the reference typhoon, and a scenario-based sea surface temperature rise value.

5. The method of claim 4, wherein, for the water depth-specific future sea temperature profile, a sea temperature distribution in the site area in a period of time of the reference typhoon and a water depth-specific change rate predicted by a climate model are used in combination.
